# EUROPEAN PATENT SPECIFICATION

(11) **EP 2 482 342 B1**
(45) Date of publication and mention of the grant of the patent: **25.09.2013**
(21) Application number: 12152638.8
(22) Date of filing: 26.01.2012
(51) Int. Cl.: H01L 33/00, H01L 25/16

(54) **Light emitting device**
Lichtemittierende Vorrichtung
Dispositif électroluminescent

(30) Priority: 26.01.2011 KR 20110007927
(43) Date of publication of application: 01.08.2012
(73) Proprietor: LG Innotek Co., Ltd., Seoul 100-714 (KR)
(72) Inventor: Lim, WooSik, 100-714 Seoul (KR)
(74) Representative: Cabinet Plasseraud

(56) References cited:
- DE-A1-102009 006 177
- US-A- 5 502 316
- US-A1- 2005 242 358

## Description

### CROSS-REFERENCE TO RELATED APPLICATION

This application claims the priority benefit of Korean Patent Application No. 10-2011-0007927, filed on January 26, 2011, the Korean Intellectual Property Office.

### BACKGROUND

### 1. Field

Embodiments relate to a light emitting device.

### 2. Description of the Related Art

A light emitting device converts electric signal into infrared light, visible light or form of a light by using of the characteristic of compound semiconductor. The light emitting devices is used in home appliances, a remote controller, an electronic display, an indicator, all kinds of automation equipments, etc. and application range of the light emitting device expands gradually.

As the application range of the light emitting device expands, lamps used in home and buildings, lamps for rescue signals, etc. require high brightness. Accordingly, it is important to increase the brightness of the light emitting device.

To increase the brightness of the light emitting device, a vertical-type light emitting device is proposed. In the vertical-type light emitting device, a light emitting structure and conductive substrate are attached on a substrate such as sapphire, and then, the substrate is separated.

However, in general, the conductive substrate being attached to the light emitting structure be made of a metal or a conductive ceramic. Therefore, the light emitting structure and the conductive substrate have different heat expand coefficients, and adhesive force between the light emitting structure and the conductive substrate decrease. Accordingly, the light emitting device has low reliability.

DE102009006177 A1 relates to a radiation-emitting semiconductor chip.

US2005242358 A1 relates to a light emitting diode and a method of fabricating the same.

US5502316 A relates to methods of fabricating light emitting diodes.

### SUMMARY

Structure and to enhance in light emission efficiency. Embodiments provide a light emitting device configured to increase bonding force between a support member and a light emitting.

Therefore, according to embodiment, a light emitting device may include a support member, a light emitting structure disposed on the support member, wherein the light emitting structure includes a first semiconductor layer, a second semiconductor layer, and an active layer between the first and second semiconductor layers, an electrode bonding layer between the support member and the light emitting structure, and a third semiconductor layer disposed between the support member and the electrode bonding layer, wherein the third semiconductor includes at least one of elements included in at least one of the first and/or second layers.

Also, according to an embodiment, as the semiconductor structure having a function of a zener diode, etc. is formed to a region in the support member, an electrostatic discharge(ESD) may not supply to light emitting structure.

Thus, it prevents damage of the light emitting device and the light emitting device may have high reliability.

### BRIEF DESCRIPTION OF THE DRAWINGS

Details of embodiments will be more clearly understood from the following detailed description taken in conjunction with the accompanying drawings, in which:
FIG. 1 is an exploded perspective view illustrating a light emitting device according to a first embodiment;
FIG. 2 is a perspective view illustrating the light emitting device of FIG. 1 when the light emitting device is assembled;
FIG. 3 is a cross-sectional perspective view illustrating the light emitting device of FIG. 2;
FIG. 4 is an exploded perspective view illustrating a light emitting device according to a second embodiment;
FIG. 5 is an exploded perspective view illustrating a light emitting device according to a third embodiment;
FIG. 6 is a perspective view illustrating a light emitting diode package including a light emitting device according to a embodiment;
FIG. 7 is a perspective view illustrating a lighting apparatus including a light emitting device according to a embodiment;
FIG. 8 is a cross-sectional view illustrating the lighting apparatus taken along a line A - A' in FIG. 7;
FIG. 9 is an exploded perspective view illustrating a liquid crystal display apparatus including a light emitting device according to a embodiment; and
FIG. 10 is an exploded perspective view illustrating a liquid crystal display apparatus including a light emitting device according to another embodiment.

### DETAILED DESCRIPTION OF EMBODIMENTS

Reference will now be made in detail to embodiments, examples of which are illustrated in the accompanying drawings. However, the present disclosure may be embodied in many different forms and should not be construed as limited to the embodiments set forth herein. Rather, these embodiments are provided so that this disclosure will be thorough and complete, and will fully convey the scope of the disclosure to those skilled in the art. The present disclosure is defined only by the the claims. In certain embodiments, detailed descriptions of device constructions or processes well known in the art may be omitted to avoid obscuring appreciation of the disclosure by a person of ordinary skill in the art. Wherever possible, the same reference numbers will be used throughout the drawings to refer to the same or like parts.

Spatially-relative terms such as "below", "beneath", "lower", "above", or "upper" may be used herein to describe one element's relationship to another element as illustrated in the Figures. It will be understood that spatially-relative terms are intended to encompass different orientations of the device in addition to the orientation depicted in the Figures. For example, if the device in one of the figures is turned over, elements described as "below" or "beneath" other elements would then be oriented "above" the other elements. The exemplary terms "below" or "beneath" can, therefore, encompass both an orientation of above and below. Since the device may be oriented in another direction, the spatially-relative terms may be interpreted in accordance with the orientation of the device.

The terminology used in the present disclosure is for the purpose of describing particular embodiments only and is not intended to limit the disclosure. As used in the disclosure and the appended claims, the singular forms "a", "an" and "the" are intended to include the plural forms as well, unless the context clearly indicates otherwise. It will be further understood that the terms "comprises" and/or "comprising," when used in this specification, specify the presence of stated features, integers, steps, operations, elements, and/or components, but do not preclude the presence or addition of one or more other features, integers, steps, operations, elements, components, and/or groups thereof.

Unless otherwise defined, all terms (including technical and scientific terms) used herein have the same meaning as commonly understood by one of ordinary skill in the art. It will be further understood that terms, such as those defined in commonly used dictionaries, should be interpreted as having a meaning that is consistent with their meaning in the context of the relevant art and the present disclosure, and will not be interpreted in an idealized or overly formal sense unless expressly so defined herein.

In the drawings, the thickness or size of each layer is exaggerated, omitted, or schematically illustrated for convenience in description and clarity. Also, the size or area of each constituent element does not entirely reflect the actual size thereof.

Angles or directions used to describe the structures of light emitting devices according to embodiments are based on those shown in the drawings. Unless there is, in the specification, no definition of a reference point to describe angular positional relations in the structures of the light emitting devices, the associated drawings may be referred to.

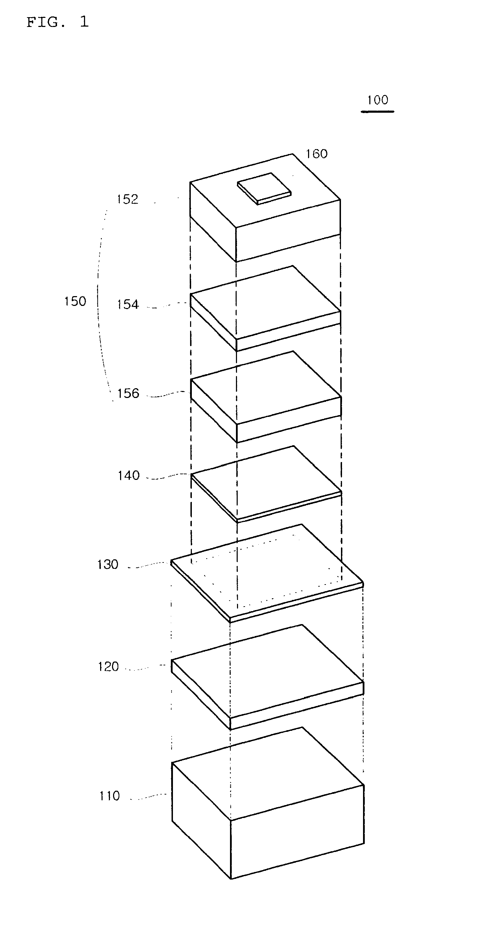

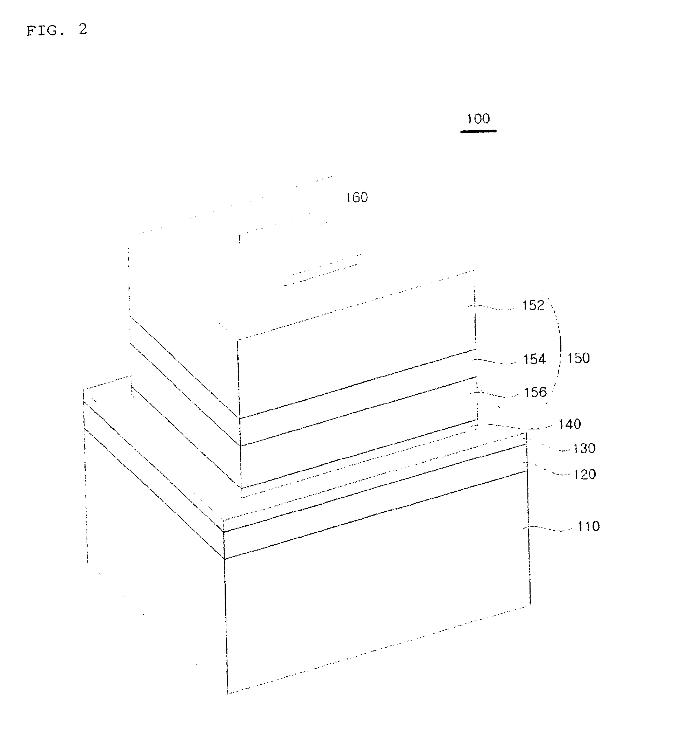

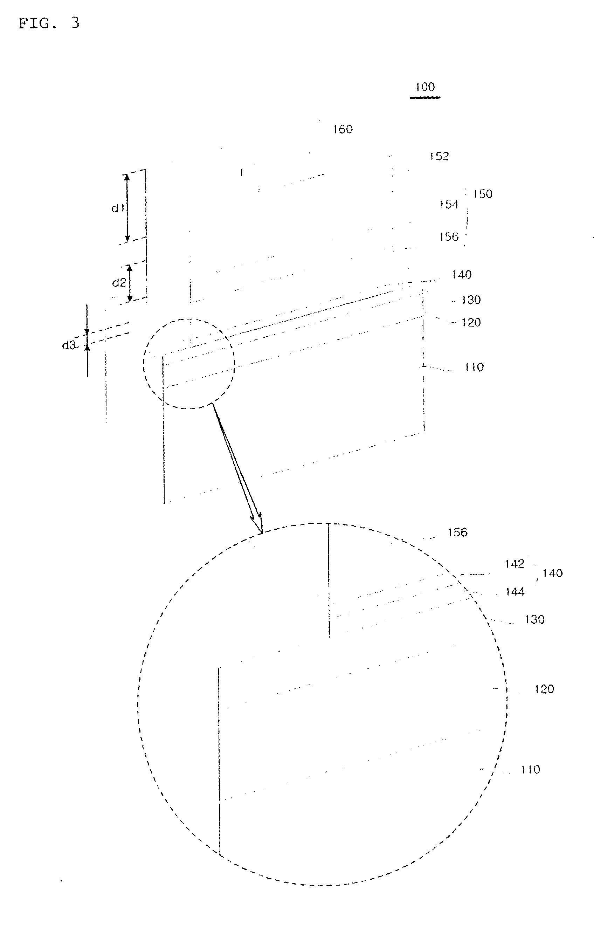

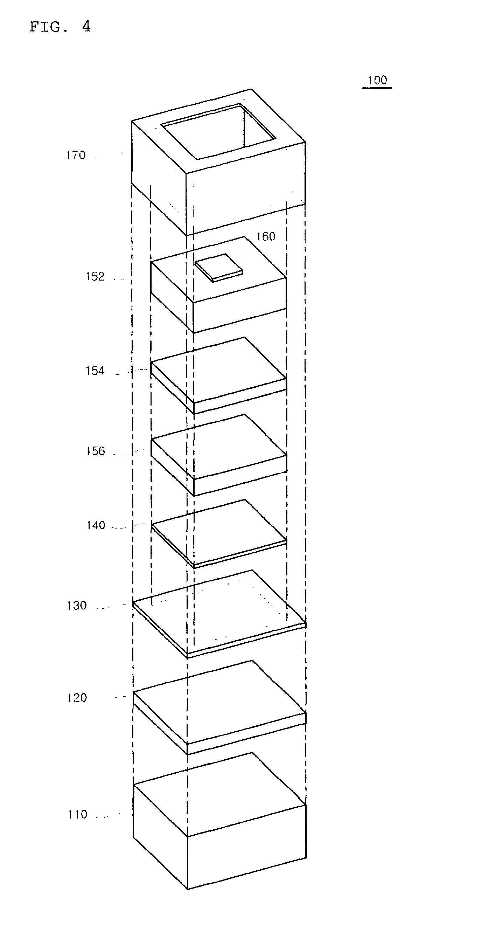

FIG. 1 is an exploded perspective view illustrating a light emitting device according to a first embodiment. FIG. 2 is a coupled perspective view illustrating the light emitting device of FIG. 1. FIG. 3 is a cross-sectional perspective view the light emitting device of FIG. 2. FIG. 4 is an exploded perspective view illustrating a light emitting device according to a second embodiment.

Referring to FIGS. 1 to 4, a light emitting device 100 may include a support member 110, and a light emitting structure 150 disposed on the support member 110.

The support member 110 may include a material having a high thermal conductivity. The support member 110 may include a conductive material and an insulating material.

Here, the support member 110 may include a single layer, or may include multiple layers having two or more layers.

When the support member 110 includes semiconductor material, the support member 110 may include carrier wafer, for example, silicon(Si), germanium(Ge), gallium-arsenide(GaAs), zinc oxide(ZnO), silicon carbide(SiC), silicon germanium(SiGe), gallium nitride(GaN) or gallium oxide(Ga2O3). In the present embodiment, the support member 110 may include silicon(si) as an example.

The support member 110 may be transparent. For example, when the support member 110 having the silicon is thinner than a predetermined thickness, the support member 110 may be transparent, but it is not limited thereto.

Also, the support member 110 may be provided, at an upper surface thereof, with a patterned sapphire substrate structure, in order to further enhance light extraction efficiency. Of course, the support member 110 is not limited to the above-described condition or structure.

Here, a third semiconductor layer 120 may be disposed on the support member 110. The third semiconductor layer 120 may include at least one element or material included in first and second semiconductor layers 152 and 156. The first and second semiconductor layers 152 and 156 will be described later.

That is, the third semiconductor layer 120 may include GaN and ZnO, and at least one of In and Al. However, it is not limited thereto.

In the embodiment, the third semiconductor layer 120 is a separate layer formed on the support member 110. However, when the third semiconductor layer 120 is grown on the third semiconductor layer 120, and the third semiconductor layer 120 is integral with the support member 110 including silicon. But it is not limited thereto.

Meanwhile, the support member 110 including silicon has a high electrical property. According to kinds of dopant of the support member 110, the third semiconductor layer 120 may have different property, but it is not limited thereto.

Here, the third semiconductor layer 120 may have a lattice constant and/or an expansion coefficient same as or similar to those of at the least one of the second semiconductor layer 156 and the support member 110 included in the light emitting structure 150.

That is, when the second semiconductor layer 156 includes a GaN layer, the third semiconductor layer 120 may include a GaN layer same as the second semiconductor layer 156.

That is, the third semiconductor layer 120 has the expansion coefficient and the lattice constant similar to those of the light emitting structure 150(that is, the second semiconductor layer 156). Therefore, a crack is not formed at an electrode bonding layer (not shown) that will be described later, even though the contractions and expansions of the light emitting device 100 are repeated by the heat generated when the light emitting device 100 operates. Accordingly, the electrode bonding layer can have a high peeling force, and the structural reliability of the light emitting device 100 can be enhanced.

Also, as the third semiconductor layer 120 is disposed or grown on the support member 110 including silicon, a plurality of dislocations generated at the support member 110 may not extend to the light emitting structure 150. After a current intensively supplied to the plurality of dislocations is diffused into the third semiconductor layer 120, the current may be supplied to the light emitting structure 150 through the electrode bonding layer (not shown). Accordingly, an electrical property of the light emitting device 100 may be improved.

Here, a thickness d3 of the third semiconductor layer 120 may be smaller than a thickness d1 of the first semiconductor 152 and a thickness d2 of the second semiconductor layer 156 that will be described later.

Here, the thickness d3 of the third semiconductor layer 120 may be about 50um to about 5um.

When the thickness d3 of the third semiconductor layer 120 is smaller than about 50um, a crack may be formed at the electrode bonding layer disposed on the third semiconductor layer 120 due to the difference of a lattice constant and an expansion coefficient between the support member 110 including silicon and the third semiconductor layer 120 increase. Accordingly, the light emitting device 100 may have low reliability.

Also, when the thickness d3 of third semiconductor layer 120 is larger than about 5um, it takes long time to manufacture the light emitting device 100. Also, the light emitting device 100 may have low efficiency.

The electrode bonding layer(not shown) may include the bonding layer 130 having conductive material and the electrode layer 140 disposed between the bonding layer 130 and the light emitting structure 150 may be formed on the third semiconductor layer 120.

The bonding layer 130 may include at least one of indium(In), tin(Sn), silver(Ag), niobium(Nb), nickel(Ni), aluminum(Al), copper(Cu), platinum(Pt), palladium(Pd), tungsten(W), ruthenium(Ru), molybdenum(Mo), iridium(Ir), rhodium(Rh), tantalum(Ta), hafnium(Hf), zirconium(Zr), vanadium(V), and alloys thereof. Therefore, the bonding layer 130 may include a single layer or multiple layers.

First of all, the electrode layer 140 electrically connected to the second semiconductor layer 156 may be disposed on the bonding layer 130.

Here, the electrode layer 140 may include a transparent electrode 142, and a reflective electrode 144 disposed between the transparent electrode 142 and the bonding layer 130.

The electrode layer 140 may include a conductive material. For example, the electrode layer 140 may include at least one of nickel(Ni), platinum(Pt), ruthenium(Ru), iridium(Ir), rhodium(Rh), tantalum(Ta), molybdenum(Mo), titanium(Ti), silver(Ag), tungsten(W), copper(Cu), chromium(Cr), palladium(Pa), vanadium(V), cobalt(Co), niob(Nb), zirconium(Zr), indium tin oxide(ITO), aluminium zinc oxide(AZO), and indium zinc oxide(IZO).

Meanwhile, it is illustrated that the transparent electrode 142 and the reflective electrode 144 have same widths. However, at least one of widths and lengths of the transparent electrode 142 and the reflective electrode 144 may be different. That is, not limited thereto.

Also, a current blocking layer (not shown) may be disposed between the electrode layer 140 and the light emitting structure 150 to prevent a current crowding phenomenon of the current supplied from the electrode layer 140. However, it is not limited thereto.

Here, the light emitting structure 150 may be disposed on the support member 110. The light emitting structure 150 may include the first and second semiconductor layers 152 and 156 and an active layer 154 disposed between the first and second semiconductor layers 152 and 156.

Here, the first semiconductor layer 152 may include compound semiconductor. For example, the first semiconductor layer 152 may be implemented using Group III-V or Group II-VI compound semiconductors. The first conductive type dopant may be doped with the first semiconductor layer 152.

That is, for example, when the first semiconductor layer 152 is an n-type semiconductor layer, the n-type semiconductor layer may include a semiconductor material having a formula of InₓAl_{y}Ga_{1-x-y}N (0≤x≤1,0≤y≤1, and 0 ≤ +y ≤ 1), for example, GaN, AlN, AlGaN, InGaN, InN, InAlGaN, or AlInN. The first semiconductor layer 152 may be doped with the n-type dopant such as Si, Ge, or Sn.

The first semiconductor layer 152 may be disposed under the active layer 154.

The active layer 154 may be region where electrons and holes are recombined. In accordance with recombination of electrons and holes, electrons and holes transit to a lower energy level. And thus, it may generate light having a wavelength corresponding to the gap of energy level.

The active layer 154 may include, for example, a semiconductor material having a formula of InₓAl_{y}Ga_{1-x-y}N (0 ≤ x ≤ 1, 0 ≤ y ≤ 1, and 0 ≤ x+y ≤ 1). The active layer 154 may have a single quantum well structure or a multi-quantum well (MQW) structure. Alternatively, the active layer 154 may include a quantum wire structure or a quantum dot structure.

The second semiconductor layer 156 may be disposed under the active layer 154.

The second semiconductor layer 156 may include semiconductor compound. For example, the first semiconductor layer 152 may be implemented using Group III-V or Group II-VI compound semiconductors. The second semiconductor layer 156 may be doped with the second conductive type dopant. For example, the second semiconductor layer 156 may be a p-type semiconductor layer, and may inject holes into the active layer 154.

In this case, the second semiconductor layer 156 may include, for example, a semiconductor material having a formula of InₓAl_{y}Ga_{1-x-y}N (0≤x≤1,0≤y≤1, and 0 ≤ x+y ≤ 1), for example, GaN, AlN, AIGaN, InGaN, InN, InAlGaN, or AlInN. The second semiconductor layer 156 may be doped with the p-type dopant such as Mg, Zn, Ca, Sr, and Ba.

Meanwhile, the first semiconductor layer 152, the active layer 154, and the second semiconductor layer 156 may be formed using a metal organic chemical vapor deposition (MOCVD) method, a chemical vapor deposition (CVD) method, a plasma-enhanced chemical vapor deposition (PECVD) method, a molecular beam epitaxy (MBE) method, a hydride vapor phase epitaxy (HVPE) methode, or a sputtering method. Of course, the manufacturing method is not limited to the above-described methods.

Also contrary to the above-described embodiment, the first semiconductor layer 152 may be a p-type semiconductor layer, and the second semiconductor layer 156 may be an n-type semiconductor layer, but it is not limited thereto.

Here, an electrode pad 160 including nickel(Ni) and so on. may be disposed on an upper surface of the first semiconductor layer 152. A roughness pattern may be partially or entirely formed on a surface of the first semiconductor layer 152. The pattern may be formed using a photo electro chemical (PEC) method, but it is not limited thereto.

Referring to FIG. 4, the protective layer 170 may be disposed on a side surface of the light emitting structure 150 and a part of the upper surface of the first semiconductor layer 152.

The protective layer 170 may include insulating material such as silicon oxide (SiO₂) silicon nitride (Si₃N₄). The protective layer 170 may include a metal having electrical conductivity lower than that of electrode layer 140 can be insulated.

The protective layer 170 may protect the light emitting structure 150 from an external impact.

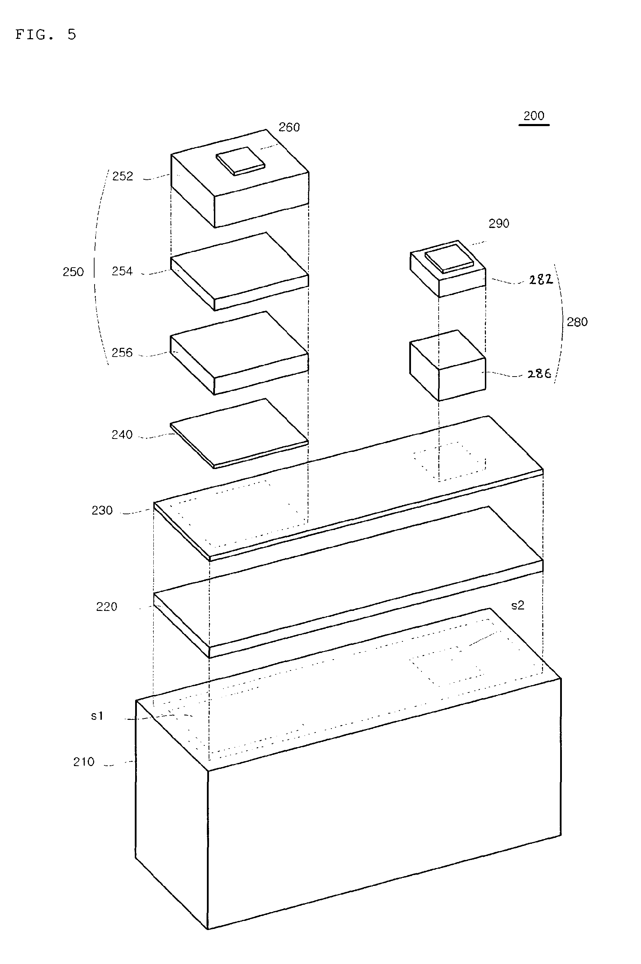

FIG. 5 is an exploded perspective view illustrating a light emitting diode according to a third embodiment.

Referring to FIG. 5, a light emitting device 200 may include a support member 210, a light emitting structure 250 disposed on the support member 210, and a semiconductor structure 280.

The support member 210 may include material having a high thermal conductive property. Also, the support member 210 may be include a conductive material, an insulating material, and a semiconductor material. When the support member 210 includes the semiconductor material, the support member 210 may include a carrier wafer such as silicon(Si), germanium(Ge), gallium-arsenide(GaAs), zinc oxide(ZnO), silicon carbide(SiC), silicon germanium(SiGe), gallium nitride(GaN) or gallium oxide(Ga2O3). In the embodiment, the support member 210 includes silicon(Si). The support member 210 is the same as the support member 110 described with reference to FIG 1. to FIG 3., thus a detailed explanation thereof is omitted.

The support member 210 may include a first and second regions S1 and S2. The light emitting structure 250 may be disposed on the first region S1, and the semiconductor structure 280 may be disposed on the second region S2. A detailed description will be described later.

A third semiconductor layer 220 may be disposed on the support member 210. The third semiconductor 220 may include at least one element included in a first and second semiconductor layers 252 and 256. That will be described later, however, it is not limited thereto.

That is, the third semiconductor layer 220 may include GaN and ZnO, at least one of the In and Al. However, it is not limited thereto.

The third semiconductor layer 220 is a layer formed on the support member 210 in the embodiment. However, the third semiconductor layer 220 is integral with the support member 210 including silicon(Si). However, it is not limited thereto.

The support member 210 including silicon(Si) has a high electrical property. The third semiconductor layer 220 may have different property according to the kinds of dopant of the third semiconductor layer 220.

The third semiconductor layer 220 may have a lattice constant and/or an expansion coefficient same as or similar to those of at least one of the second semiconductor layer 256 and the support member 210.

That is, when the second semiconductor layer 256 includes a GaN layer, the third semiconductor layer 220 may include a GaN layer same as the second semiconductor layer 256.

That is, the third semiconductor layer 220 has the expansion coefficient and the lattice constant similar to those of the light emitting structure 250(that is, the second semiconductor layer 256). Therefore, a crack is not formed at an electrode bonding layer (not shown) that will be described later, even though the contractions and the expansions of the light emitting device 200 are repeated by heat generated when the light emitting device 200 operates. Accordingly, the electrode bonding layer can have a high peeling force, and the structural reliability of the light emitting device 200 can be enhanced.

Also, as the third semiconductor layer 220 is disposed or grown on the support member 210 including silicon, a plurality of dislocations generated at the support member 210 do not extend to the light emitting structure 250. After a current intensively supplied to the plurality of dislocations may diffused into the third semiconductor layer 220, the current may be supplied to the light emitting structure 250 through the electrode bonding layer (not shown), thus an electrical property of the light emitting device 200 may be improved.

The thickness of the third semiconductor layer 220 may be smaller than the first and second semiconductor layers 252 and 256. The first and second semiconductor layers 252 and 256 will be described later.

The thickness d3 of the third semiconductor layer 220 may be about 50um to about 5um.

When the thickness of the third semiconductor layer 220 is smaller than about 50um, a crack may be formed at the electrode bonding layer disposed on the third semiconductor layer 220 due to the difference of a lattice constant and an expansion coefficient between the support member 210 including silicon(Si) and the third semiconductor layer 220 increase. Accordingly, the light emitting device 100 may have low reliability.

Also, when the thickness of third semiconductor layer 220 is larger than about 5um, it takes long time to manufacture the light emitting device 200. Also, the light emitting device 200 may have low efficiency.

The electrode bonding layer (not shown) may be formed on the third semiconductor layer 220. The electrode bonding layer may include the bonding layer 230 and the electrode layer 240 disposed between the bonding layer 230 and the light emitting structure 250.

The bonding layer 230 and the electrode layer 240 are the same as the bonding layer 130 and the electrode layer 140 described with reference to FIG.1 to FIG 3., and a detailed explanation thereof is omitted.

Also, the light emitting structure 250 and the semiconductor structure 280 may be disposed on the electrode layer 240.

Here, the light emitting structure 250 may be disposed on the electrode layer 240 corresponding to the first region S1 of the support member 210. The light emitting structure 250 is the same as the light emitting structure 150 described with reference to FIG.1 to FIG 3., and a detailed explanation thereof is omitted.

Also, the electrode pad 260 may be disposed on the first semiconductor layer 252 of the light emitting structure 250. However, it is not limited thereto.

The semiconductor structure 280 may include a fourth and fifth semiconductor layers 286 and 282. The fourth semiconductor layer 286 may be doped with dopant same as the dopant of the first semiconductor layer 252, and the fourth semiconductor layer 286 may have a composition same as the composition of the first semiconductor layer 252. However, it is not limited thereto.

Also, the fifth semiconductor layer 282 may be doped with dopant same as dopant of the second semiconductor layer 256, and the fifth semiconductor layer 282 has a composition same as a composition of the second semiconductor layer 256. However, it is not limited thereto.

Namely, the support member 210 including Si may have a high electrical property, and semiconductor layers having different characteristic according to kinds of dopant of the support member 210 can be formed. Accordingly, an integrated electronic circuit may be formed.

In other words, the integrated electronic circuit may be a transistor and a diode including P-N junction. However, it is not limited thereto.

The semiconductor structure 280 illustrated in FIG. 5 is a diode. When an inverse voltage supplies to the light emitting device 200, the semiconductor structure 280 is connected to the light emitting structure 250 in anti parallel in order to bypass the inverse voltage. Thus, it prevents damage of the light emitting device 200.

Namely, the semiconductor structure 280 may be a constant voltage device such as a zener diode. However, it is not limited thereto.

Here, an electrode 290 connected to the electrode pad 260 electrically may be disposed on the fifth semiconductor layer 282. The electrode 290 may have a material same as a material of at least one of the electrode pad 260 and the electrode layer 240. However, it is not limited thereto.

Also, the protective layer (not shown) may disposed on a part of a side surface of the light emitting structure 250 and an upper surface of the first semiconductor layer 252. However, it is not limited thereto.

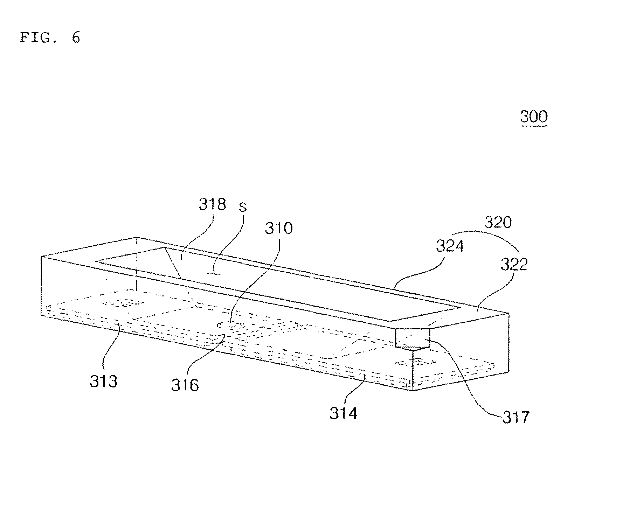

FIG. 6 is a perspective view illustrating a light emitting device package including a light emitting device according to the embodiment.
FIG. 6 is a penetrating perspective view illustrating a part of the light emitting device package 300 by penetrating, the light emitting device package 300 is illustrated top view type in the embodiment, however it may be side view type, is not limited thereto.

Referring to FIG. 6, the light emitting device package 300 may include the light emitting device 310 and the body 320, on which the light emitting device 310.

The body 320 may include the first partition 322 disposed for a first direction(not shown) and the second partition 324 disposed for a second direction(not shown) intersecting with the first direction. The first partition 322 may be integral with the second partition 324, formed using injection molding, etching, etc., however it is not limited thereto.

Namely, the first and second partitions 322 and 324 may include at least one of material of resin as polyphthalamide(PPA), silicon(Si), aluminum(Al), aluminum nitride(AlN), AlOx, photo sensitive glass(PSG), polyamide9T(PA9T), syndiotactic polystyrene(SPS), metallic material, sapphire(Al2O3), beryllium oxide(BeO), ceramic, and printed circuit board(PCB).

The first and second partitions 322 and 324 may have various shape of upper surface according to use and design, however it is not limited thereto.

Also, the first and second partitions 322 and 324 may form a cavity(s), on which the light emitting device 310 is disposed. The cavity(s) may have a sectional shape as cup shape, concave container shape, etc. The first and second partitions 322 and 324 may be formed inclined for downward direction.

And the cavity(s) may have a various plane shape as triangle, rectangular, polygon, and circle etc., however it is not limited thereto.

The first and second lead frames 313 and 314 may be disposed on the bottom surface of the body 320. The first and second lead frames 313 and 314 may include a metal for example at least one of titanium(Ti), copper(Cu), nickel(Ni), gold(Au), chromium(Cr), tantalum(Ta), platinum(Pt), tin(Sn), silver(Ag), aluminum(Al), indium(In), palladium(Pd), cobalt(Co), silicon(Si), germanium(Ge), hafnium(Hf), ruthenium(Ru) and iron(Fe) or alloys of thereof.

And the first and second lead frames 313 and 314 may include a single layer or multiple layers, however it is not limited thereto.

An inner side surface of the first and second partitions 322 and 324 may be inclined with a predetermined angle of incline with reference to at least one of the first and second lead frames 313 and 314.

The reflective angle of a light emitted from the light emitting device 310 may be different according to the angle of incline. So, an orientation angle of the light emitted to the outside may be controlled. The light emitted from the light emitting device 310 to the outside concentrates more, as the oriental angle of the light decreases. On the other hand, the light emitted from the light emitting device 310 to the outside concentrates less, as the orientation angle of the light increases.

The inner side surface of the body 320 may have a plurality of angles of incline, however it is not limited thereto.

The first and second lead frames 313 and 314 are electrically connected to the light emitting device 310, are connected to positive (+) and negative (-) electrodes of outer power source (not shown) respectively, may supply power to the light emitting device 310.

In this embodiment, the light emitting device 310 is disposed on the first lead frame 313, the second lead frame 314 is apart from the first lead frame 313. The light emitting device 310 is die-bonded to the first lead frame 313 and is wire-bonded to the second lead frame 314 by wire (not shown) to receive power from the first and second lead frames 313 and 314.

Here, the light emitting device 310 may be bonded to the first and second lead frames 313 and 314, which have different polarities.

Also, the light emitting device 310 may be wire-bonded or die-bonded to the first and second lead frames 313 and 314 respectively, without being limited in terms of connection formation method.

In the embodiment, the light emitting device 310 is disposed on the first lead frame 313, however it is not limited thereto.

In addition, the light emitting device 310 may be adhered to the first lead frame 313 by an adhesive member (not shown), the light emitting device 310 is at least one of the light emitting devices above-described and a description of the light emitting device 310 is omitted.

Here, an insulating dam 316 may be formed between the first and second lead frames 313 and 314 to prevent an electrical short between the first and second lead frames 313 and 314.

In this embodiment, the insulating dam 316 may have semi-circular top and the shape of thereof is not limited thereto.

A cathode mark 317 may be formed to the body 313.

The light emitting device 310 may be a light emitting diode. The light emitting diode may be a color light emitting diode emitting colored light such as red, green, blue, white, or an ultraviolet (UV) light emitting diode emitting ultraviolet light, without being limited thereto.

Also, the light emitting device 310 mounted on the first lead frame 313 may be present in plural, at least one of the light emitting device may be mounted on the first and second lead frame 313 and 314 respectively, the number and position of the light emitting device 310 are not limited.

The body 320 may include a resin material 318 filled in the cavity(s). That is, the resin material may be formed a double molding structure or a triple molding structure and is not limited thereto.

In addition, the resin material 318 may be formed film type, include at least one of a phosphor and a light diffusion material, also, the resin material 318 may include light-transmitting material not containing a phosphor and a light diffusion material, but is not limited thereto.

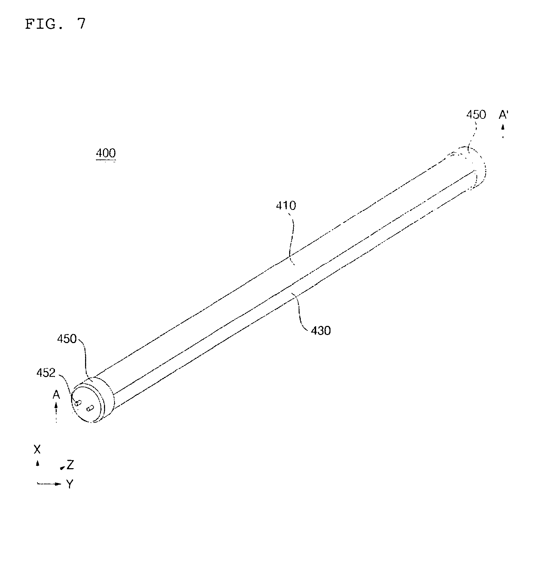

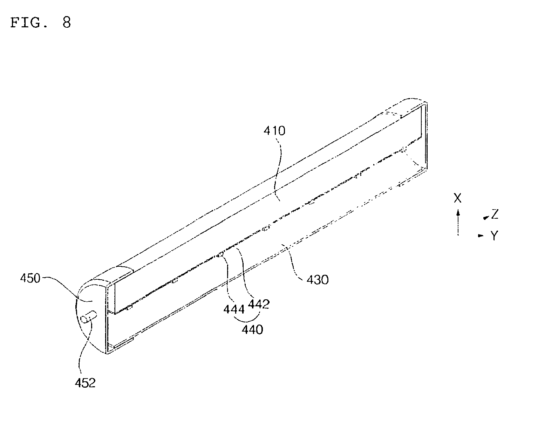

FIG. 7 is a perspective view illustrating a lighting apparatus including a light emitting device according to an embodiment, and FIG. 8 is a cross-sectional view taken along a line A - A' in FIG. 7.

Hereinafter, for better understanding, the lighting device 400 will be described based on a longitudinal direction (Z), a horizontal direction (Y) vertical to the longitudinal direction (Z), and a height direction (X) vertical to the longitudinal direction (Z) and the horizontal direction (Y).

That is, FIG. 8 is a sectional view of the lighting device 400 of FIG. 7, taken along the cross-section of the longitudinal direction (Z) and height direction (X) and seen from the horizontal direction (Y).

Referring to FIGS. 7 and 8, the lighting device 400 may include a body 410, a cover 430 connected to the body 410 and an end cap 450 arranged at both ends of the body 410.

A light emitting device module 440 is connected to the bottom of the body 410 and the body 410 may be composed of a metal which exhibits superior conductivity and excellent heat release effects in order to discharge heat generated from light emitting device packages 444 to the outside through the top of the body 410.

The light emitting device packages 444 exhibit improved bonding reliability and luminous efficacy and are advantageous in designing slim and small display devices due to roughness (not shown) provided in each lead frame (not shown).

The light emitting device packages 444 are mounted in multiple colors and multiple rows on the PCB 442 to form an array and may be spaced from one another by a predetermined distance or by different distances, as necessary, to control brightness. The PCB 442 may be a metal core PCB (MCPCB) or a PCB made of FR4.

The cover 430 may take the shape of a circle to surround the bottom of the body 410, without being limited thereto.

The cover 430 protects the light emitting device module 440 from foreign substances. In addition, the cover 430 prevents glare generated from the light emitting device package 444 and includes diffusion particles to uniformly discharge light to the outside. In addition, a prism pattern or the like may be formed on at least one of the inner and outer surfaces of the cover 430. Alternatively, a phosphor may be applied to at least one of the inner and outer surfaces of the cover 430.

Meanwhile, the cover 430 should exhibit superior light transmittance, so that it can discharge light generated from the light emitting device package 444 through the cover 430 to the outside, and the cover 430 should exhibit sufficient heat resistance so that it can endure heat emitted by the light emitting device package 444. Preferably, the cover 430 is composed of a material including polyethylene terephthalate (PET), polycarbonate (PC), polymethyl methacrylate (PMMA) and the like.

The end cap 450 is arranged on both ends of the body 410 and may be used to seal a power device (not shown). In addition, the end cap 450 is provided with a power pin 452, allowing the lighting device 400 to be applied to a conventional terminal from which fluorescent light has been removed, without using any additional device.

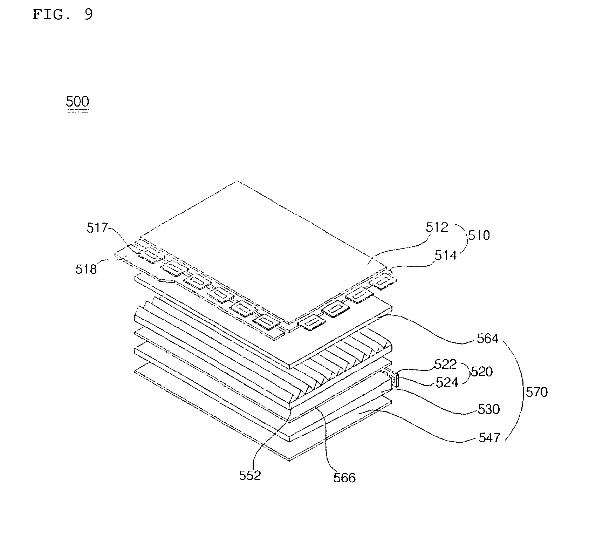

FIG. 9 is an exploded perspective view illustrating a liquid crystal display apparatus including a light emitting device according to an embodiment.
FIG. 9 illustrates an edge-light type liquid crystal display device 500 which includes a liquid crystal display panel 510 and a backlight unit 570 to supply light to the liquid crystal display panel 510.

The liquid crystal display panel 510 displays an image using light supplied from the backlight unit 570. The liquid crystal display panel 510 includes a color filter substrate 512 and a thin film transistor substrate 514 which face each other such that a liquid crystal is disposed therebetween.

The color filter substrate 512 can realize color images to be displayed through the liquid crystal display panel 510.

The thin film transistor substrate 514 is electrically connected to a printed circuit board 518 on which a plurality of circuit components is mounted through a driving film 517. The thin film transistor substrate 514 responds to driving signals supplied from the printed circuit board 518 and may apply driving voltage from the printed circuit board 518 to liquid crystals.

The thin film transistor substrate 514 includes a thin film transistor and a pixel electrode formed as a thin film on other substrates composed of a transparent material such as glass or plastic.

The backlight unit 570 includes a light emitting device module 520 to emit light, a light guide plate 530 to convert light emitted from the light emitting device module 520 into surface light and supply the light to the liquid crystal display panel 510, a plurality of films 550, 566 and 564 to uniformize brightness of light from the light guide plate 530 and improve vertical incidence, and a reflective sheet 540 to reflect light emitted to the back of the light guide plate 530 to the light guide plate 530.

The light emitting device module 520 includes a plurality of light emitting device packages 524 and a PCB 522 on which the light emitting device packages 524 are mounted to form an array.

Meanwhile, the backlight unit 570 includes a diffusion film 566 to diffuse light incident from the light guide plate 530 toward the liquid crystal display panel 510, a prism film 550 to concentrate the diffused light and thus improve vertical incidence and a protective film 564 to protect the prism film 550.

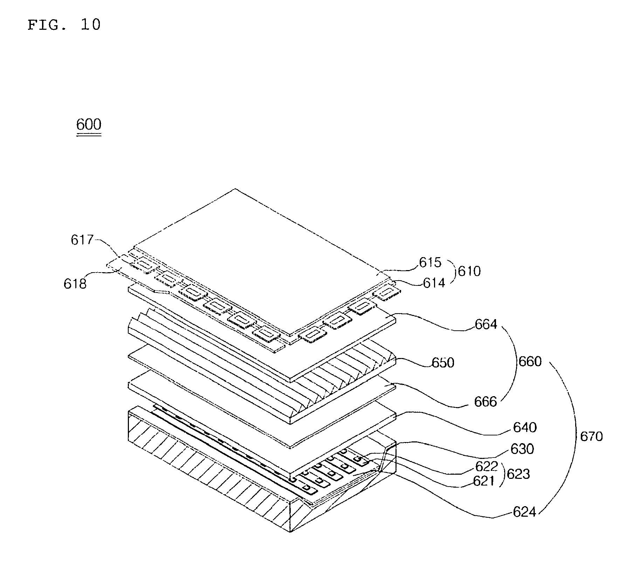

FIG. 10 is an exploded perspective view illustrating a liquid crystal display apparatus including a light emitting device according to another embodiment.

The contents illustrated and described in FIG. 9 are not mentioned in detail.

FIG. 10 illustrates a direct-type liquid crystal display device 600 which includes a liquid crystal display panel 610 and a backlight unit 670 to supply light to the liquid crystal display panel 610.

The liquid crystal display panel 610 has been described in FIG. 9 and a detailed explanation thereof is thus omitted.

The backlight unit 670 may include a plurality of light emitting device modules 623, a reflective sheet 624, a lower chassis 630 in which the light emitting device modules 623 and the reflective sheet 624 are accepted, and a diffusion plate 640 and a plurality of optical films 660 arranged on the light emitting device modules 623.

Each light emitting device module 623 includes a plurality of light emitting device packages and a PCB 621 on which the light emitting device packages 624 are mounted to form an array.

In particular, the light emitting device package 622 exhibits improved bonding reliability and realizes slim and further reliable backlight units 670 due to the roughness 170 formed in a region where the light source unit 130 and a wire 150 are wire-bonded to respective lead frames 140 and 142.

The reflective sheet 624 reflects light generated by the light emitting device package 622 toward the liquid crystal display panel 610 to improve luminous efficacy.

Meanwhile, light emitted from the light emitting device module 623 is incident on the diffusion plate 640 and an optical film 660 is arranged on the diffusion plate 640. The optical film 660 includes a diffusion film 666, a prism film 650 and a protective film 664.

In the embodiments, the lighting device 400 and liquid crystal displays 500 and 600 may be included in the lighting system and a lighting device including a light emitting device package may be included in the lighting system.

A light emitting device as embodied and broadly described herein may allow which exhibits improved luminous efficacy, reduces drive voltage, and improves safety and reliability.

Any reference in this specification to "one embodiment," "an embodiment," "example embodiment," etc., means that a particular feature, structure, or characteristic described in connection with the embodiment is included in at least one embodiment. The appearances of such phrases in various places in the specification are not necessarily all referring to the same embodiment. Further, when a particular feature, structure, or characteristic is described in connection with any embodiment, it is submitted that it is within the purview of one skilled in the art to effect such feature, structure, or characteristic in connection with other ones of the embodiments.

Although embodiments have been described with reference to a number of illustrative embodiments thereof, it should be understood that numerous other modifications and embodiments can be devised by those skilled in the art. More particularly, various variations and modifications are possible in the component parts and/or arrangements of the subject combination arrangement within the scope of the appended claims. In addition to variations and modifications in the component parts and/or arrangements, alternative uses will also be apparent to those skilled in the art.

## Claims

1. A light emitting device comprising:
a support member (110, 210);
a light emitting structure (150, 250) disposed on the support member, wherein the light emitting structure includes a first semiconductor layer (152, 252), a second semiconductor layer (156, 256), and an active layer (154, 254) between the first and second semiconductor layers; and
an electrode bonding layer disposed between the support member and the light emitting structure;
**characterised in that** said light emitting device further comprises:
a third semiconductor layer (120, 220) disposed between the support member and the electrode bonding layer, wherein the third semiconductor includes at least one of the elements included in at least one of the first and second layers.

2. The light emitting device of claim 1, wherein the third semiconductor layer includes at least one of In, Al, and/or ZnO.

3. The light emitting device of claim 1, wherein the third semiconductor layer is disposed adjacent to the second semiconductor layer,
wherein the at least one of a lattice constant and an expansion coefficient of the third semiconductor layer is the same as those of at least one of the second semiconductor layer and/or the support member.

4. The light emitting device of claim 1, wherein a thickness of the third semiconductor is smaller than a thickness of at least one of the first and/or the second semiconductor layer.

5. The light emitting device of claim 1, wherein the thickness of the third semiconductor layer is between 0.05µm and 5µm.

6. The light emitting device of claim 1, wherein the third semiconductor has an uneven surface where the electrode bonding layer is disposed.

7. The light emitting device of claim 1, wherein the electrode bonding layer includes:
a bonding layer (130, 230) disposed on the third semiconductor layer and including conductive material; and
an electrode layer (140, 240) disposed between the bonding layer and the light emitting structure.

8. The light emitting device of claim 7, wherein the electrode layer includes a reflective electrode (144) and a transparent electrode (142) disposed between the reflective electrode and the light emitting structure.

9. The light emitting device of claim 1, wherein the support member includes a semiconductor material including silicon.

10. The light emitting device of claim 1, wherein the support member has a pattern on a surface, on which the third semiconductor layer disposed.

11. The light emitting device of claim 1, further comprising:
a protective layer (170) disposed on a side surface of the light emitting structure.

12. The light emitting device of claims 1, wherein the first semiconductor layer has a rough upper surface.

13. The light emitting device of claim 1, further comprising:
an electrode pad (160, 260) disposed on an upper surface of the first semiconductor layer.

14. The light emitting device of claim 1, wherein the support member includes a first region (S1) vertically overlapped with the light emitting structure and a second region (S2) spaced apart from the first region,
wherein a semiconductor structure (280) disposed on the second region, includes a fourth semiconductor layer (286) including a material which is the same as a material of the first semiconductor layer and a fifth semiconductor layer (282) including a material which is the same as a material of the second semiconductor layer.

15. A lighting system comprising a light emitting device according to any one of claims 1 to 14.

## Patentansprüche

1. Lichtemittierende Vorrichtung, die aufweist:
ein Halteelement (110, 210);
eine lichtemittierende Struktur (150, 250), die auf dem Halteelement angeordnet ist, wobei die lichtemittierende Struktur eine erste Halbleiterschicht (152, 252), eine zweite Halbleiterschicht (156, 256) und eine aktive Schicht (154, 254) zwischen den ersten und zweiten Halbleiterschichten aufweist; und
eine Elektrodenverbindungsschicht, die zwischen dem Halteelement und der lichtemittierenden Struktur angeordnet ist;
**dadurch gekennzeichnet, dass** die lichtemittierende Vorrichtung ferner aufweist:
eine dritte Halbleiterschicht (120, 220), die zwischen dem Halteelement und der Elektrodenverbindungsschicht angeordnet ist, wobei der dritte Halbleiter wenigstens eines der Elemente umfasst, das in der ersten und/oder zweiten Schicht enthalten ist.

2. Lichtemittierende Vorrichtung nach Anspruch 1, wobei die dritte Halbleiterschicht In und/oder A1 und/oder ZnO enthält.

3. Lichtemittierende Vorrichtung nach Anspruch 1, wobei die dritte Halbleiterschicht benachbart zu der zweiten Halbleiterschicht angeordnet ist,
wobei eine Gitterkonstante und/oder ein Ausdehnungskoeffizient der dritten Halbleiterschicht gleich denen der zweiten Halbleiterschicht und/oder des Halteelements ist/sind.

4. Lichtemittierende Vorrichtung nach Anspruch 1, wobei eine Dicke des dritten Halbleiters kleiner als eine Dicke der ersten und/oder der zweiten Halbleiterschicht ist.

5. Lichtemittierende Vorrichtung nach Anspruch 1, wobei die Dicke der dritten Halbleiterschicht zwischen 0,05 µm und 5 µm liegt.

6. Lichtemittierende Vorrichtung nach Anspruch 1, wobei der dritte Halbleiter eine unebene Oberfläche hat, auf welcher die Elektrodenverbindungsschicht angeordnet ist.

7. Lichtemittierende Vorrichtung nach Anspruch 1, wobei die Elektrodenverbindungsschicht umfasst:
eine Verbindungsschicht (130, 230), die auf der dritten Halbleiterschicht angeordnet ist und die leitendes Material enthält; und
eine Elektrodenschicht (140, 240), die zwischen der Verbindungsschicht und der lichtemittierenden Struktur angeordnet ist.

8. Lichtemittierende Vorrichtung nach Anspruch 7, wobei die Elektrodenschicht eine reflektierende Elektrode (144) und eine transparente Elektrode (142) umfasst, die zwischen der reflektierenden Elektrode und der lichtemittierenden Struktur angeordnet ist.

9. Lichtemittierende Vorrichtung nach Anspruch 1, wobei das Halteelement ein Halbleitermaterial umfasst, das Silizium enthält.

10. Lichtemittierende Vorrichtung nach Anspruch 1, wobei das Halteelement ein Muster auf einer Oberfläche hat, auf der die dritte Halbleiterschicht angeordnet ist.

11. Lichtemittierende Vorrichtung nach Anspruch 1, die ferner aufweist:
eine Schutzschicht (170), die auf einer Seitenfläche der lichtemittierenden Struktur angeordnet ist.

12. Lichtemittierende Vorrichtung nach Anspruch 1, wobei die erste Halbleiterschicht eine raue Oberseite hat.

13. Lichtemittierende Vorrichtung nach Anspruch 1, die ferner aufweist:
einen Elektrodenkontaktfleck (160, 260), der auf einer Oberseite der ersten Halbleiterschicht angeordnet ist.

14. Lichtemittierende Vorrichtung nach Anspruch 1, wobei das Halteelement einen ersten Bereich (S1), der mit der lichtemittierenden Struktur vertikal überlappt, und einen zweiten Bereich (S2), der von dem ersten Bereich beabstandet ist, umfasst,
wobei eine Halbleiterstruktur (280), die auf dem zweiten Bereich angeordnet ist, eine vierte Halbleiterschicht (286), die ein Material enthält, welches das gleiche wie ein Material der ersten Halbleiterschicht ist, und eine fünfte Halbleiterschicht (282) aufweist, welche ein Material enthält, welches das gleiche wie ein Material der zweiten Halbleiterschicht ist.

15. Beleuchtungssystem, das eine lichtemittierende Vorrichtung nach einem der Ansprüche 1 bis 14 aufweist.

## Revendications

1. Dispositif électroluminescent comprenant :
un élément de support (110, 210) ;
une structure électroluminescente (150, 250) disposée sur l'élément de support, dans lequel la structure électroluminescente comprend une première couche semi-conductrice (152, 252), une deuxième couche semi-conductrice (156, 256), et une couche active (154, 254) entre les première et deuxième couches semi-conductrices ; et
une couche de liage d'électrode disposée entre l'élément de support et la structure électroluminescente ; **caractérisé en ce que** ledit dispositif électroluminescent comprend en outre :
une troisième couche semi-conductrice (120, 220) disposée entre l'élément de support et la couche de liage d'électrode, dans lequel la troisième couche semi-conductrice comprend au moins un des éléments inclus dans au moins une des première et deuxième couches.

2. Dispositif électroluminescent selon la revendication 1, dans lequel la troisième couche semi-conductrice comprend au moins un parmi In, Al et/ou ZnO.

3. Dispositif électroluminescent selon la revendication 1, dans lequel la troisième couche semi-conductrice est disposée de façon adjacente à la deuxième couche semi-conductrice,
dans lequel l'au moins un parmi une constante de réseau et un coefficient de dilatation de la troisième couche semi-conductrice est le même que ceux d'au moins un parmi la deuxième couche semi-conductrice et/ou l'élément de support.

4. Dispositif électroluminescent selon la revendication 1, dans lequel une épaisseur de la troisième couche semi-conductrice est inférieure à une épaisseur d'au moins une des première et/ou deuxième couches semi-conductrices.

5. Dispositif électroluminescent selon la revendication 1, dans lequel l'épaisseur de la troisième couche semi-conductrice est entre 0,05 µm et 5 µm.

6. Dispositif électroluminescent selon la revendication 1, dans lequel la troisième couche semi-conductrice possède une surface irrégulière où la couche de liage d'électrode est disposée.

7. Dispositif électroluminescent selon la revendication 1, dans lequel la couche de liage d'électrode comprend :
une couche de liage (130, 230) disposée sur la troisième couche semi-conductrice et comprenant un matériau conducteur ; et
une couche d'électrode (140, 240) disposée entre la couche de liage et la structure électroluminescente.

8. Dispositif électroluminescent selon la revendication 7, dans lequel la couche d'électrode comprend une électrode réfléchissante (144) et une électrode transparente (142) disposée entre l'électrode réfléchissante et la structure électroluminescente.

9. Dispositif électroluminescent selon la revendication 1, dans lequel l'élément de support comprend un matériau semi-conducteur comprenant du silicium.

10. Dispositif électroluminescent selon la revendication 1, dans lequel l'élément de support comporte un motif sur une surface, sur laquelle la troisième couche semi-conductrice est disposée.

11. Dispositif électroluminescent selon la revendication 1, comprenant en outre :
une couche protectrice (170) disposée sur une surface latérale de la structure électroluminescente.

12. Dispositif électroluminescent selon la revendication 1, dans lequel la première couche semi-conductrice possède une surface supérieure rugueuse.

13. Dispositif électroluminescent selon la revendication 1, comprenant en outre :
une pastille électrode (160, 260) disposée sur une surface supérieure de la première couche semi-conductrice.

14. Dispositif électroluminescent selon la revendication 1, dans lequel l'élément de support comprend une première région (S1), que la structure électroluminescente chevauche verticalement, et une seconde région (S2) espacée de la première région, dans lequel une structure à semi-conducteur (280) disposée sur la seconde région comprend une quatrième couche semi-conductrice (286) comprenant un matériau qui est le même qu'un matériau de la première couche semi-conductrice et une cinquième couche semi-conductrice (282) comprenant un matériau qui est le même qu'un matériau de la deuxième couche semi-conductrice.

15. Système d'éclairage comprenant un dispositif électroluminescent selon une quelconque des revendications 1 à 14.
